(19) Europäisches Patentamt
European Patent Office
Office européen des brevets

(11) **EP 2 463 919 A1**

(12) **EUROPEAN PATENT APPLICATION**
published in accordance with Art. 153(4) EPC

(43) Date of publication:
**13.06.2012 Bulletin 2012/24**

(51) Int Cl.:
*H01L 31/042* (2006.01)     *C08J 3/22* (2006.01)
*C08K 5/14* (2006.01)     *C08K 5/54* (2006.01)
*C08L 23/08* (2006.01)     *C09K 3/10* (2006.01)

(21) Application number: **10806556.6**

(22) Date of filing: **06.08.2010**

(86) International application number:
**PCT/JP2010/063388**

(87) International publication number:
**WO 2011/016557 (10.02.2011 Gazette 2011/06)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **07.08.2009 JP 2009185272**
**11.11.2009 JP 2009257586**
**16.07.2010 JP 2010161237**

(71) Applicants:
• **TOYO INK MFG. CO., LTD.**
**Tokyo (JP)**

• **Toyochem Co., Ltd.**
**Tokyo 104-8379 (JP)**

(72) Inventors:
• **FUKDOME Yasuhiro**
**Tokyo 104-8377 (JP)**
• **SAKAI Takashi**
**Tokyo 104-8377 (JP)**

(74) Representative: **HOFFMANN EITLE**
**Patent- und Rechtsanwälte**
**Arabellastraße 4**
**81925 München (DE)**

(54) **METHOD FOR PRODUCING RESIN COMPOSITION FOR SOLAR CELL SEALING MATERIAL, RESIN COMPOSITION FOR SOLAR CELL SEALING MATERIAL, SOLAR CELL SEALING MATERIAL, AND SOLAR CELL MODULE**

(57) An object of the present invention is to provide a method for producing a resin composition for solar cell sealing material which is capable of lowering a cost by shortening of a processing time and has good storage stability. Further, another object of the present invention is to provide a solar cell sealing material having excellent transparency due to no generation of lumps therein by using the obtained resin composition for solar cell sealing material. A method for producing a resin composition for solar cell sealing material according to the present invention includes: preparing an ethylene-vinyl acetate copolymer (A) containing a vinyl acetate unit in an amount of 25 to 35 wt% and a crosslinking agent (B), whose impregnation weight with respect to 1 g of the ethylene-vinyl acetate copolymer (A) per 24 hours at a temperature of 23°C is in the range of 40 to 80 mg, as raw components; and impregnating the crosslinking agent (B) into the ethylene-vinyl acetate copolymer (A) at a temperature of 15 to 80°C.

EP 2 463 919 A1

**Description**

## TECHNICAL FIELD

The present invention relates to a method for producing a resin composition for solar cell sealing material, a resin composition for solar cell sealing material, a solar cell sealing material, and a solar cell module.

## BACKGROUND ART

Recently, a solar cell is spotlighted due to a growing environmental problem. In general, the solar cell is composed of a plurality of solar cell modules. Such a solar cell module has a structure in which a protective glass, a solar cell sealing material, a solar cell element, a solar cell sealing material and a back sheet are laminated in this order from a sunlight receiving side thereof. From the viewpoint of transparency, mechanical physicality and cost, a sheet made of a resin composition containing an ethylene-vinyl acetate copolymer is generally used as the solar cell sealing material.

This resin composition, that is, the resin composition for solar cell sealing material usually contains a crosslinking agent alone or a crosslinking agent and a crosslinking auxiliary agent in order to improve durability of the solar cell sealing material by closslinking molecules of the ethylene-vinyl acetate copolymer which is one of raw components thereof. Further, in general, the resin composition for solar cell sealing material also contains a silane coupling agent in order to maintain appropriate adhesion with respect to a surface of the protective glass or the solar cell element.

The resin composition for solar cell sealing material can be produced using various methods. Examples of a method for producing the resin composition for solar cell sealing material include: a method in which a crosslinking agent, a crosslinking auxiliary agent and a silane coupling agent are kneaded into an ethylene-vinyl acetate copolymer using a melting kneader such as a biaxial extruder (see, Patent document 1); and a method in which a crosslinking agent in a liquid state, a crosslinking auxiliary agent in a liquid state and the like are mixed with an ethylene-vinyl acetate copolymer using a blender such as a mixer to obtain a mixture, and then the mixture is left for a whole day and night in order to completely impregnate the above agents into the ethylene-vinyl acetate copolymer (see, Patent document 2).

However, according to the method described in the Patent document 1, when the raw components are molten and kneaded, a crosslinking reaction of the crosslinking agent has to be controlled. However, even if extrusion kneading is carried out at a low temperature, it is impossible to practically prevent the crosslinking reaction of the crosslinking agent due to shear heat which would be locally generated in the molten resin material. Therefore, in the solar cell sealing material molded into a sheet shape, local crosslinked portions of the molecules of the ethylene-vinyl acetate copolymer (that is, so-called "lumps") are generated. This causes deterioration of the solar cell sealing material in quality due to ununiformity of a sheet thickness or lowering of transparency thereof.

On the other hand, according to the method described in the Patent document 2, as described above, since the mixture is left for a whole day and night, it takes time to produce the resin composition for solar cell sealing material. Therefore, there are problems in that productivity thereof is low and a cost thereof becomes high.

Patent document 1: JP-A 2000-84967
Patent document 2: JP-A 2006-186233

## DISCLOSURE OF THE INVENTION

An object of the present invention is to provide a method for producing a resin composition for solar cell sealing material which is used for molding a solar cell sealing material, a resin composition for solar cell sealing material, a solar cell sealing material, and a solar cell module.

More specifically, an object of the present invention is to provide a method for producing a resin composition for solar cell sealing material which has good storage stability, is capable of lowering a cost by shortening of a processing time in manufacturing a solar cell sealing material, and can manufacture a solar cell sealing material having excellent transparency by drastically reducing the number of lumps to be generated therein, a resin composition for solar cell sealing material produced by such a method for producing a resin composition for solar cell sealing material, and a solar cell sealing material and a solar cell module each manufactured using such a resin composition for solar cell sealing material.

Among the present inventions, a first invention relates to a method for producing a resin composition for solar cell sealing material, comprising:

preparing an ethylene-vinyl acetate copolymer (A) containing a vinyl acetate unit in an amount of 25 to 35 wt% and a crosslinking agent (B), whose impregnation weight with respect to 1 g of the ethylene-vinyl acetate copolymer (A) per 24 hours at a temperature of 23°C is in the range of 40 to 80 mg, as raw components; and
impregnating the crosslinking agent (B) into the ethylene-vinyl acetate copolymer (A) at a temperature of 15 to 80°C.

A second invention relates to the method for producing a resin composition for solar cell sealing material of the above invention, wherein surface tension of the crosslinking agent (B) is in the range of 23 to 28 mN/m.

A third invention relates to the method for producing a resin composition for solar cell sealing material of the above invention, wherein in the raw components preparing step, a crosslinking auxiliary agent (C), whose impregnation weight with respect to 1 g of the ethylene-vinyl acetate copolymer (A) per 24 hours at a temperature of 23°C is in the range of 80 to 120 mg and whose surface tension is in the range of 33 to 38 mN/m, is further prepared as the raw components, and

wherein in the crosslinking agent (B) impregnating step, the crosslinking auxiliary agent (C) is impregnated into the ethylene-vinyl acetate copolymer (A) together with the crosslinking agent (B).

A fourth invention relates to the method for producing a resin composition for solar cell sealing material of the above invention, wherein in the raw components preparing step, a silane coupling agent (D), whose impregnation weight with respect to 1 g of the ethylene-vinyl acetate copolymer (A) per 24 hours at a temperature of 23°C is in the range of 80 to 150 mg and whose surface tension is in the range of 27 to 32 mN/m, is further prepared as the raw components, and wherein in the crosslinking agent (B) impregnating step, the silane coupling agent (D) is impregnated into the ethylene-vinyl acetate copolymer (A) together with the crosslinking agent (B).

A fifth invention relates to resin composition for solar cell sealing material being produced using the method for producing a resin composition for solar cell sealing material of the above invention.

A sixth invention relates to a solar cell sealing material being molded using an ethylene-vinyl acetate copolymer and the resin material for solar cell sealing material of the above invention.

A seventh invention relates to a method for molding a solar cell sealing material, comprising:

preparing an ethylene-vinyl acetate copolymer (A) containing a vinyl acetate unit in an amount of 25 to 35 wt% and a crosslinking agent (B), whose impregnation weight with respect to 1 g of the ethylene-vinyl acetate copolymer (A) per 24 hours at a temperature of 23°C is in the range of 40 to 80 mg, as raw components;
impregnating the crosslinking agent (B) into the ethylene-vinyl acetate copolymer (A) at a temperature of 15 to 80°C, to produce a master batch for solar cell sealing material;
mixing the produced master batch for solar cell sealing material with an ethylene-vinyl acetate copolymer while being heated, to obtain a mixture; and
molding the obtained mixture using a molding machine, to obtain the solar cell sealing material.

A eighth invention relates to a solar cell module being manufactured by sealing a solar cell element with the solar cell sealing material of the above invention or a solar cell sealing material molded by the method for molding a solar cell sealing material of the above invention.

## EFFECT OF THE INVENTION

A resin composition for solar cell sealing material obtained by a method for producing a resin composition for solar cell sealing material can have good storage stability, and by using this resin composition in manufacturing a solar cell sealing material, it is possible to lower a cost by shortening of a processing time thereof. Further, use of this resin composition for solar cell sealing material also makes it possible to obtain a solar cell sealing material having excellent transparency by drastically reducing the number of lumps to be generated therein.

## BEST MODE FOR CARRYING OUT THE INVENTION

A method for producing a resin composition for solar cell sealing material includes a step of impregnating a crosslinking agent (B) in a liquid state into an ethylene-Vinyl acetate copolymer (A) containing a vinyl acetate unit in an amount of 25 to 35 wt% at a temperature of 15 to 80°C (hereinbelow, this step is referred to as "impregnating step" on occasion For example, by impregnating the crosslinking agent (B) and the like into the ethylene-vinyl acetate copolymer (A) in high concentrations, a resin composition for solar cell sealing material can be obtained as a master batch (master batch for solar cell sealing material). Further, according to the present invention, it is also possible to obtain a master batch into which a crosslinking auxiliary agent (C) and/or a silane coupling agent (D) are impregnated in addition to the crosslinking agent (B) in high concentrations.

Hereinbelow, in this embodiment, description will be representatively made on a case that an ethylene-vinyl acetate copolymer (A) in a pellet form is used. Therefore, a resin composition for solar cell sealing material to be produced also has a pellet form. In this regard, it is to be noted that examples of the form (shape) of the ethylene-vinyl acetate copolymer (A) include a powdered form, a granulated form, an aggregated form, a block form and the like, in addition to the pellet form.

Further, in the following description, pellets of the ethylene-vinyl acetate copolymer (A) are referred to as "raw pellets" and pellets of a resin composition for solar cell sealing material to be produced are simply referred to as "pellets", respectively, on occasion.

The ethylene-vinyl acetate copolymer (A) containing the vinyl acetate unit in the amount of 25 to 35 wt%, which is used in the present invention, means a polymer obtained by polymerizing ethylene and vinyl acetate, which are monomers, so as to adjust an amount of the vinyl acetate to 25 to 35 parts by weight when a total amount of the ethylene and the vinyl acetate is defined as "100 parts by weight".

Here, the ethylene-vinyl acetate copolymer (A) (hereinbelow, it is referred to as "EVA" on occasion) tends to have a low degree of crystallinity according to increase of a ratio of the vinyl acetate unit (wt%). Therefore, if the vinyl acetate unit is less than 25 wt%, since the ethylene-vinyl acetate copolymer (A) has a high degree of crystallinity, an impregnation ratio of raw components in liquid states such as the crosslinking agent (B) thereinto is lowered. On the other hand, if the vinyl acetate unit exceeds 35 wt%, since the ethylene-vinyl acetate copolymer (A) has a too low degree of crystallinity, the impregnated crosslinking agent (B) moves on surfaces of the pellets. This may cause a problem such as blocking of the pellets which would occur due to moderate adhesion therebetween.

Further, in the present invention, a melt flow rate (JIS K7210) of the ethylene-vinyl acetate copolymer (A) is preferably in the range of 0.1 to 60 g/10 min, and more preferably in the range of 0.5 to 45 g/10 min in view of moldability (formability), mechanical strength or the like thereof. Furthermore, in the case where the resin composition for solar cell sealing material is produced as the master batch, since diffusibility of the master batch into a diluent resin has to be considered in addition to the moldability, the mechanical strength or the like, the melt flow rate of the ethylene-vinyl acetate copolymer (A) (hereinbelow, it is referred to as "MFR" on occasion) is preferably in the range of 2 to 50 g/10 min, and more preferably in the range of 5 to 45 g/10 min.

By using the ethylene-vinyl acetate copolymer (A) having such a range of the melt flow rate, since the raw components can be impregnated deep inside the produced pellets and held by the ethylene-vinyl acetate copolymer (A) more reliably, it becomes difficult for the raw components to move on the surfaces of the pellets. In this regard, it is to be noted that the master batch will be described in detail below.

In the present invention, it is important that a impregnation weight of the crosslinking agent (B) with respect to 1 g of the ethylene-vinyl acetate copolymer (A) per 24 hours at a temperature of 23°C is in the range of 40 to 80 mg. Especially, the impregnation weight of the crosslinking agent (B) is preferably in the range of 50 to 70 mg/EVA·1 g. By using the crosslinking agent (B) having the impregnation weight falling within the above value range, it is possible to decrease troubles such as occurrence of the blocking, moving of the crosslinking agent (B) on the surfaces of the pellets and the like, and to produce the resin composition for solar cell sealing material (pellets) in a short period of time.

Here, the impregnation weight can be obtained as follows. Namely, the crosslinking agent (B) is prepared in a sufficient amount with respect to pellets of an ethylene-vinyl acetate copolymer (A) containing a vinyl acetate unit in an amount of 30 wt%, "X" g of the pellets of the ethylene-vinyl acetate copolymer (A) is dipped into the crosslinking agent (B) at 23°C for 24 hours, the pellets are removed from the crosslinking agent (B), and then the crosslinking agent (B) adhering to surfaces of the pellets is sufficiently wiped away therefrom.

Thereafter, a weight of the pellets after the dipping is measured, and then an impregnation weight "Y" g of the crosslinking agent (B), which is a difference between the measured weight and the weight "X" g of the pellets before the dipping, is divided by the weight "X" g of the pellets before the dipping, to thereby be converted into a weight per 1 g of the ethylene-vinyl acetate copolymer (A). In this regard, it is to be noted that "EVA" means an ethylene-vinyl acetate copolymer.

$$\text{Impregnation weight (mg/EVA·1 g)} = (Y/X) \times 1,000$$

Examples of the crosslinking agent (B) include tert-butyl peroxy isopropyl carbonate, tert-butyl peroxy-2-ethyl hexyl carbonate, tert-butyl peroxy acetate, tert-butyl cumyl peroxide, 2,5-dimethyl-2,5-di(tert-butyl peroxy) hexane, di-tert-butyl peroxide, 2,5-dimethyl-2,5-di(tert-butyl peroxy) hexyne-3, 2,5-dimethyl-2,5-di(tert-butyl peroxy) hexane, 1,1-di(tert-hexyl peroxy)-3,3,5-trimethyl cyclohexane, 1,1-di(tert-butyl peroxy) cyclohexane, 1,1-di(tert-hexyl peroxy) cyclohexane, 1,1-di(tert-amyl peroxy) cyclohexane, 2, 2-di (tert-butyl peroxy) butane, methyl ethyl ketone peroxide, 2,5-dimethyl hexyl-2,5-diperoxy benzoate, tert-butyl hydroperoxide, p-menthane hydroperoxide, dibenzoyl peroxide, p-chlorbenzoyl peroxide, tert-butyl peroxy isobutylate, n-butyl-4,4-di(tert-butyl peroxy) valerate, ethyl-3,3-di(tert-butyl peroxy) butylate, hydroxyheptyl peroxide, dichlohexanone peroxide, 1,1-di(tert-butyl peroxy) 3,3,5-trimethyl cyclohexane, n-butyl-4,4-di (tert-butyl peroxy) valerate, 2,2-di(tert-butyl peroxy) butane, and the like.

A mixing amount of the crosslinking agent (B) is preferably in the range of 0.3 to 20 parts by weight, and more preferably in the range of 0.3 to 10 parts by weight with respect to 100 parts by weight of the ethylene-vinyl acetate copolymer (A). In the case where the resin composition for solar cell sealing material (pellets) is produced as the master batch containing the crosslinking agent (B) in the high concentration by the method for producing a resin composition for solar cell sealing material according to the present invention, this master batch contains the crosslinking agent (B) preferably in the range of 5 to 60 parts by weight, more preferably in the range of 15 to 60 parts by weight, and even more preferably in the range of 15 to 45 parts by weight with respect to 100 parts by weight of the ethylene-vinyl acetate copolymer (A).

Further, it is preferred that surface tension of the crosslinking agent (B) is in the range of 23 to 28 mN/m. If the surface tension is less than 23 mN/m, the crosslinking agent (B) tends to easily move on the surfaces of the pellets depending on an environmental temperature or the like when storing the pellets (resin composition for solar cell sealing material). This may lead to occurrence of blocking and pollution of a working environment. On the other hand, if the surface tension exceeds 28 mN/m, there is a case that a time necessary to sufficiently impregnate the crosslinking agent (B) into the raw pellets becomes too long.

In the present invention, a processing temperature during the impregnating step is preferably in the range of 15 to 80°C, more preferably in the range of 30 to 70°C and even more preferably in the range of 40 to 70°C. If the processing temperature exceeds the above upper limit value, there is a fear that reaction of the crosslinking agent (B) or melt of the ethylene-vinyl acetate copolymer (A) occurs, depending on conditions such as a stirring speed during the impregnating step. On the other hand, the processing temperature is lower than the above lower limit value, there is a case that a time necessary to sufficiently impregnate the crosslinking agent (B) into the raw pellets becomes too long.

Further, a time necessary during the impregnating step is not limited to a specific value, but is preferably in the range of about 5 minutes to 2 hours, and more preferably in the range of about 5 minutes to 1 hour. By setting the time to a value within the above range, it is possible to impregnate the crosslinking agent (B) into the raw pellets in a necessary and sufficient amount. Further, even in the case where the processing temperature during the impregnating step is relatively high, it is possible to appropriately prevent or suppress crosslinking reaction of the crosslinking agent (B) from being generated.

In the impregnating step, it is preferred that a crosslinking auxiliary agent (C) and/or a silane coupling agent (D) are/is impregnated into the raw pellets together with the crosslinking agent (B).

It is preferred that an impregnation weight of the crosslinking auxiliary agent (C) with respect to 1 g of the ethylene-vinyl acetate copolymer (A) per 24 hours at a temperature of 23°C is in the range of 80 to 120 mg and surface tension thereof is in the range of 33 to 38 mN/m, from the viewpoint of impregnation efficiency thereof into the ethylene-vinyl acetate copolymer (A) (raw pellets). Examples of such a crosslinking auxiliary agent (C) include triallyl isocyanurate, triallyl cyanurate, styrene and the like.

A mixing amount of the crosslinking auxiliary agent (C) is preferably in the range of 0.3 to 15 parts by weight, and more preferably in the range of 0.3 to 10 parts by weight with respect to 100 parts by weight of the ethylene-vinyl acetate copolymer (A). In the case where the resin composition for solar cell sealing material (pellets) is produced as the master batch containing the crosslinking agent (B) and the crosslinking auxiliary agent (C) in the high concentrations by the method for producing a resin composition for solar cell sealing material according to the present invention, this master batch contains the crosslinking auxiliary agent (C) preferably in the range of 5 to 60 parts by weight, more preferably in the range of 15 to 60 parts by weight, and even more preferably in the range of 15 to 45 parts by weight with respect to 100 parts by weight of the ethylene-vinyl acetate copolymer (A).

It is preferred that an impregnation weight of the silane coupling agent (D) with respect to 1 g of the ethylene-vinyl acetate copolymer (A) per 24 hours at a temperature of 23°C is in the range of 80 to 150 mg and surface tension thereof is in the range of 27 to 32 mN/m, from the viewpoint of impregnation efficiency thereof into the ethylene-vinyl acetate copolymer (A) (raw pellets).

Examples of such a silane coupling agent (D) include γ-methacryloxy propyl trimethoxy silane, γ-methacryloxy propyl triethoxy silane, γ-methacryloxy propyl methyl dimethoxy silane, vinyl tris(β-methoxy ethoxy) silane, vinyl triacetoxy silane, N-(β-amino ethyl)-γ-amino propyl trimethoxy silane, N-β-amino ethyl)-γ-amino propyl methyl dimethoxy silane, γ-mercapto propyl triethoxy silane, and the like.

A mixing amount of the silane coupling agent (D) is preferably in the range of 0.1 to 10 parts by weight, and more preferably in the range of 0.1 to 5 parts by weight with respect to 100 parts by weight of the ethylene-vinyl acetate copolymer (A). In the case where the resin composition for solar cell sealing material (pellets) is produced as the master batch containing the crosslinking agent (B) and the silane coupling agent (D) in the high concentrations by the method for producing a resin composition for solar cell sealing material according to the present invention, this master batch contains the silane coupling agent (D) preferably in the range of 5 to 60 parts by weight, more preferably in the range of 15 to 60 parts by weight, and even more preferably in the range of 15 to 45 parts by weight with respect to 100 parts by weight of the ethylene-vinyl acetate copolymer (A).

In the impregnating step, it is preferable to use equipment capable of mixing or stirring each raw component within a container, and more preferable to use equipment capable of heating and cooling it. Even if the used equipment does not have a heating system, since the raw components can be heated due to self-heating which would occur by friction thereof when being stirred, it is possible to sufficiently carry out the present invention. On the other hand, even if the used equipment does not have a cooling system, since generation of heat can be prevented or suppressed by, for example, controlling a rotating speed of an impeller provided in the equipment, it is also possible to carry out the present invention. Examples of such equipment include autoclave equipment provided with a stirrer, a Henschel mixer, a lady gel mixer, a super mixer and the like.

By mixing and stirring the ethylene-vinyl acetate copolymer (A), the crosslinking agent (B) and the other raw components within the container at the same time, it is possible to impregnate the crosslinking agent (B) and the like into the ethylene-vinyl acetate copolymer (A) together. However, the impregnation may be carried out by putting the raw components into the container in an arbitrary order.

The other various kinds of additive agents can be further added to the resin composition for solar cell sealing material of the present invention, if needed. Examples of such additive agents include an ultraviolet light absorber, a photostabilizer, an antioxidant, a wavelength conversion agent, a coloring agent, a light dispersion agent, a flame retardant, an antitarnish agent, and the like. The various kinds of additive agents may be mixed together with at least one of the ethylene-vinyl acetate copolymer (A), the crosslinking agent (B), the crosslinking auxiliary agent (C) and the silane coupling agent (D) to produce the resin composition for solar cell sealing material, or may be separately added to (impregnated into) a final molded product (e.g. a solar cell sealing material which will be described below).

In the present invention, the master batch means a resin composition for solar cell sealing material produced by impregnating, for example, the crosslinking agent (B) into the ethylene-vinyl acetate copolymer (A) in a high concentration. Namely, the master batch means a resin composition for solar cell sealing material in a pellet form. Such a resin composition for solar cell sealing material is used for preparing a material of molding a solar cell sealing material having a sheet shape (hereinbelow, it is referred to as "solar cell sealing material sheet" on occasion) when molding the solar cell sealing material sheet. This molding material can be prepared by mixing and kneading (diluting) the resin composition for solar cell sealing material and the dilution resin so that the amount of the crosslinking agent (B) contained in the molding material to be obtained is adjusted to a desired value.

As such a dilution resin, it is possible to use the same resin as the ethylene-vinyl acetate copolymer (A) used for producing the above-mentioned resin composition for solar cell sealing material, or a resin having compatibility with the ethylene-vinyl acetate copolymer (A). Examples of the resin having compatibility with the ethylene-vinyl acetate copolymer (A) include polyethylene, polypropylene, an ethylene-propylene copolymer, and the like.

In the present invention, in the case where the resin composition for solar cell sealing material is produced as the master batch, this master batch can further contain at least one of the crosslinking auxiliary agent (C) and the silane coupling agent (D). In this case, it is preferred that the master batch contains all of the crosslinking agent (B), the crosslinking auxiliary agent (C) and the silane coupling agent (D) in high concentrations.

Further, in the present invention, a volatilization rate of a peroxide to be used such as the crosslinking agent (B) is higher in the case of molding a solar cell sealing material using the resin composition for solar cell sealing material which has been produced as the master batch than in the case of molding a solar cell sealing material using the resin composition for solar cell sealing material which has been produced without the master batch (e.g., the peroxide decreases in the range of about 1 to 5% per hour at 50°C). Therefore, it is preferable to produce a master batch having a relatively small specific surface.

In the case where a solar cell sealing material is molded using the master batch having the relatively small specific surface, it is possible to suppress the peroxide from vaporizing from the master batch. Further, in the case where a solar cell sealing material is molded using the master batch, it is also possible to prevent clouding of the solar cell sealing material which would occur due to crosslinking ununiformity or decrease of gel fraction therein. Furthermore, even if a solar cell sealing material having a sheet shape is molded, it becomes possible to prevent lowering of a mechanical physical property thereof.

On the other hand, in the present invention, a compound means a resin composition for solar cell sealing material in a pellet form, which really contains the raw components such as the crosslinking agent (B) in such concentrations (percentage contents) that is required in the solar cell sealing material sheet, that is, the molded product. Such a compound is directly used for molding the solar cell sealing material without being diluted.

As described above, the solar cell sealing material of the present invention can be obtained by directly molding the resin composition for solar cell sealing material of the present invention so as to have a sheet shape or the like. Further, such a solar cell sealing material can be also obtained by, for example, subjecting the resin composition for solar cell sealing material, which has been produced as the master batch, to adjustment such as dilution, and then molding it so as to have the sheet shape or the like. In general, the solar cell sealing material sheet can be molded by a molding method using a T-die extrusion machine, a calender molding machine or the like. It is preferred that a thickness of the thus molded solar cell sealing material is in the range of about 0.01 to 1 mm.

A solar cell module of the present invention can be manufactured by fixing the above solar cell sealing material sheets to a solar cell element (photoelectric conversion element) using upper and lower protective members (including transparent substrates). The solar cell module can be manufactured by sandwiching (securing) the solar cell element between the solar cell sealing material sheets, but is, generally, manufactured by bonding the solar cell sealing material sheets thereto by being heated and pressed using a vacuum laminating machine.

Examples of a structure of such a solar cell module include: a structure in which the transparent substrate, the solar cell sealing material sheet, the solar cell element, the solar cell sealing material sheet and the protective member are laminated together in this order, that is, a super straight structure in which the solar cell element is sandwiched between the solar cell sealing material sheets; and a structure in which the transparent substrate, the solar cell element, the solar cell sealing material sheet and the protective member are laminated together in this order, that is, a structure in which the solar cell sealing material sheet and the protective member are laminated to the solar cell element provided on a surface of the transparent substrate in this order.

As the transparent substrate, used is a thermally tempered white glass plate or a transparent sheet, and as the solar cell sealing material sheet, used is a sheet having excellent moisture resistance, which is molded using the resin composition for solar cell sealing material of the present invention. Further, as the protective member requiring moisture resistance and an insulating property, used is a sheet having a structure in which an aluminum sheet is sandwiched between polyvinyl fluoride sheets or a sheet having a structure in which an aluminum sheet is sandwiched between polyethylene terephthalate sheets each having an anti-hydrolytic property.

## Examples

Hereinbelow, the present invention will be concretely described by showing Examples and Comparative Examples, but is not limited to the following Examples as long as not exceeding the purpose of the present invention. In this regard, it is to be noted that "parts" and "%" shown in Examples and Comparative Examples mean "parts by weight" and "wt%", respectively.

Various kinds of raw components used in Examples and Comparative Examples are as follows.

Ethylene-vinyl acetate copolymer

(A-1) Vinyl acetate wt%: 26%, MFR: 25 g/10 min
(A-2) Vinyl acetate wt%: 33%, MFR: 34 g/10 min
(A-3) Vinyl acetate wt%: 23%, MFR: 18 g/10 min
(A-4) Vinyl acetate wt%: 37%, MFR: 42 g/10 min

Crosslinking agent

(B-1) 2,5-dimethyl-2,5-di(tert-butyl peroxy) hexane
(B-2) 1,1-di(tert-butyl peroxy)-3,3,5-trimethyl cyclohexane
(B-3) Tert-butyl peroxy-2-ethyl hexyl carbonate
(B-4) 2,5-dimethyl-2,5-di(tert-butyl peroxy) hexane
(B-5) 2,5-dimethyl-2,5-di(benzoyl peroxy) hexane
(B-6) 1,1-di(tert-butyl peroxy)-2-methyl cyclohexane
(B-7) Tert-butyl peroxy benzoate

Crosslinking auxiliary agent

(C-1) Triallyl isocyanurate
(C-2) Ethylene glycol diacrylate
(C-3) Diallyl fumarate

Silane coupling agent

(D-1) γ-methacryloxy propyl trimethoxy silane
(D-2) γ-methacryloxy propyl methyl dimethoxy silane
(D-3) γ-amino propyl triethoxy silane
(D-4) 3-glycidoxy propyl trimethoxy silane

Each of the crosslinking agents (B-1) to (B-7), the crosslinking auxiliary agents (C-1) to (C-3) and the silane coupling agents (D-1) to (D-4) was prepared as an intended measuring liquid, and then an impregnation weight and surface tension thereof was measured. A method for measuring each of the impregnation weight and the surface tension was as follows. These measuring results are shown in Table 1.

[Impregnation weight (mg/EVA·1 g)]

The intended measuring liquid was prepared in a sufficient amount with respect to pellets of an ethylene-vinyl acetate copolymer containing a vinyl acetate unit in an amount of 30 wt%, "X" g of the pellets of the ethylene-vinyl acetate copolymer was dipped into the intended measuring liquid at 23°C for 24 hours, the pellets were removed from the intended measuring liquid, and then the intended measuring liquid adhering to surfaces of the pellets was sufficiently wiped away therefrom.

Thereafter, a weight of the pellets after the dipping was measured, and then an impregnation weight "Y" g of the intended measuring liquid was obtained by subtracting the weight "X" g of the pellets before the dipping from the measured weight. And then, the impregnation weight was converted into an impregnation weight of the intended measuring liquid per 1 g of the ethylene-vinyl acetate copolymer (mg/EVA·1 g) based on a expression of $(Y/X) \times 1,000$.

[Surface tension]

The surface tension of the intended measuring liquid was measured at 23°C using an automatic tensiometer ("CBVP-Z" produced by Kyowa Interface Science Co., LTD.).
[Table 1]

Table 1

| | | Impregnation weight (mg/EVA·1 g) | Surface tension (mN/m) |
|---|---|---|---|
| Crosslinking agent | B-1 | 42 | 24 |
| | B-2 | 46 | 24 |
| | B-3 | 78 | 27 |
| | B-4 | 65 | 26 |
| | B-5 | 27 | 29 |
| | B-6 | 35 | 21 |
| | B-7 | 90 | 21 |
| Crosslinking auxiliary agent | C-1 | 92 | 36 |
| | C-2 | 149 | 31 |
| | C-3 | 66 | 35 |
| Silane coupling agent | D-1 | 100 | 29 |
| | D-2 | 134 | 28 |
| | D-3 | 97 | 26 |
| | D-4 | 56 | 31 |

Hereinbelow, description will be made on a measuring method, evaluation method and integrated evaluation method each used in Examples and Comparative Examples, and the way for carrying out each of Examples and Comparative Examples.

[Measurement of impregnation yield]

Each of the crosslinking agents (B-1) to (B-7), the crosslinking auxiliary agents (C-1) to (C-3) and the silane coupling agents (D-1) to (D-4) was prepared as an intended measuring raw component, and then an impregnation yield thereof was measured.
An impregnation ratio "p"% was obtained by quantifying the raw component (impregnation raw component) impregnated into pellets of a resin composition for solar cell sealing material or a resin composition for solar cell sealing material produced as a master batch. In the case where a feed amount of this raw component was "q"%, the impregnation yield can be calculated based on the following expression of [impregnation yield = $p/q \times 100$].
In this regard, an analytical sample was obtained by subjecting the pellets to an extraction treatment, and then analyzing this analytical sample using a gas chromatography according to an external standard method, to thereby carry out the quantification of the impregnation raw component. A method for the extraction treatment and measuring conditions are shown below.

<Extraction treatment>

(1) The pellets were freeze-dried by liquid nitrogen, and then passed through a sieve of 32 mesh, to thereby collect pellets passed therethrough.

(2) About 0.5 g of these pellets was put into a 5 ml measuring flask, and then acetone was added to the pellets and left out at normal temperature for a whole day and night, to thereby obtain an extract. This extract was used as the analytical sample.

<Conditions for gas chromatography>

Equipment: "GC-9AM" produced by Shimadzu Corporation
Column: "Rtx-1701" having an internal diameter of 0.25 mm and a length of 60 m
Column temperature: 210°C
Sample vaporizing chamber temperature: 120°C
Detector temperature: 250°C
Sample amount: 1 $\mu$L
Mobile phase: nitrogen, 45 mL/min
Detector: FID

In the case of one impregnation raw component, an evaluation criteria based on the measured result of the impregnation yield is as follows.

A: 95% or more
B: 90% or more, but less than 95%
C: Less than 90%

In the case of two or more impregnation raw components, an evaluation criteria based on the measured results of the impregnation yields is as follows.

A: 90% or more in all components
B: 75% or more, but less than 90% in all components
C: Less than 75% in all components

[Storage stability evaluation]

Pellets of a resin composition for solar cell sealing material or a resin composition for solar cell sealing material produced as a master batch, in which each above intended measuring raw component was adjusted in an impregnation yield of "r"%, were left at 35°C for 1,000 hours, and then an impregnation yield "s"% of each impregnation raw component in the left pellets was measured by quantifying it (raw component impregnated).

Thereafter, a residual ratio was calculated based on the following expression of [residual ratio = s/r $\times$ 100], and then storage stability evaluation of the pellets of the resin composition for solar cell sealing material or the resin composition for solar cell sealing material produced as the master batch was evaluated.

The quantification of each impregnation raw component was carried out according to the same extraction treatment and measuring conditions as described in the item of the impregnation yield.

A storage stability evaluation criteria based on the residual ratio calculated based on the above expression is as follows.

A: 99% or more
B: 95% or more, but less than 99%
C: Less than 95%

[Blocking evaluation]

A weight "a"g of the pellets of the resin composition for solar cell sealing material or the resin composition for solar cell sealing material produced as the master batch was left at 30°C for 1 hour, and then a weight of blocking lumps, which had been generated, was measured.

Thereafter, a blocking ratio was calculated based on the following expression of [blocking ratio = b/a × 100]. In this regard, each blocking lump means a lump which is generated by bonding the plurality of pellets together and cannot pass through a sieve having an opening size of 1 cm in this evaluation.

A blocking evaluation criteria based on the blocking ratio calculated based on the above expression is as follows.

> A: 1% or more, but less than 5%
> B: 5% or more, but less than 30%
> C: 30% or more

[Appearance evaluation

The pellets of the resin composition for solar cell sealing material or the resin composition for solar cell sealing material produced as the master batch were left at 30°C for 1 hour, a state of appearance of the pellets was evaluated by visual observation.

An appearance evaluation criteria is as follows.

> A: It is hardly observed that the raw component (s) move (s) on surfaces of the pellets.
> B: It is observed that the raw component(s) partially move(s) on the surfaces of the pellets as occurrence of droplets.
> C: It is observed that the raw component(s) move(s) on the whole surfaces of the pellets.

[Lump evaluation]

A solar cell sealing material sheet having a thickness of 100 $\mu$m was manufactured by molding the pellets of the resin composition for solar cell sealing material or a mixture of the pellets of the resin composition for solar cell sealing material produced as the master batch and a dilution resin at a molding temperature of 80°C using an extruder ("Laboplastomill" produced by TOYO SEIKI Co., Ltd.). The number of lumps generated within 0.3 m$^2$ of the sheet was measured and defined as "m". Further, in the same way, a sheet was manufactured by molding an ethylene-vinyl acetate copolymer, and then the number of lumps generated within the sheet was measured and defined as "n".

Thereafter, a lump evaluation was carried out based on a substantial number of lumps calculated according to the following expression of [substantial number of lumps = m-n]. In this regard, each lump means a local crosslinking potion generated in the sheet and having a length of 100 $\mu$m or more in a major axis direction thereof.

A lump evaluation criteria based on the substantial number of lumps calculated based on the above expression is as follows.

> A: less than 5
> B: 5 or more, but less than 20
> C: 20% or more

[Integrated evaluation]

According to the results of the evaluation based on the measurement of impregnation yield, the storage stability evaluation, the blocking evaluation, the appearance evaluation and the lump evaluation, the integrated evaluation is carried out based on the following evaluation criteria. Namely, defined is a more preferable solar cell sealing material as "4", a preferable solar cell sealing material as "3", an useable solar cell sealing material as "2", or an unuseable solar cell sealing material as "1". The result of the integrated evaluation is shown in Tables 2 and 3.

In the case of one impregnation raw component, the integrated evaluation "4" means that all evaluation items are shown as "A". The integrated evaluation "3" means that all evaluation items are shown as "A" or "B" but the number of "B" is 1. The integrated evaluation "2" means that all evaluation items are shown as "A" or "B" but the number of "B" is 2. The integrated evaluation "1" means that all evaluation items are shown as "A" or "B" but the number of "B" is 3 or more, or at least one of the evaluation items is shown as "C".

Further, in the case of 2 impregnation raw components, the integrated evaluation "4" means that all evaluation items are shown as "A". The integrated evaluation "3" means that all evaluation items are shown as "A" or "B" but the number of "B" is 1 or 2. The integrated evaluation "2" means that all evaluation items are shown as "A" or "B" but the number of "B" is 3 or more. The integrated evaluation "1" means that at least one of the evaluation items is shown as "C".

(Example 1)

3, 600 parts of the ethylene-vinyl acetate copolymer (A-1) in the pellet form and 400 parts of the crosslinking agent (B-1) were put into a 20 L mixer provided with a heating system (produced by KAWATA MFG CO., LTD.), and then mixed for 30 minutes at 500 rpm while being controlled at 40°C. In this way, produced were pellets of a resin composition for solar cell sealing material. The impregnation yield of the crosslinking agent (B-1) in these pellets was measured. Further, the storage stability evaluation, the blocking evaluation and the appearance evaluation of these pellets were carried out.

Further, a test sheet (solar cell sealing material sheet) having a thickness of 100 μm was obtained by molding the pellets produced by the impregnation method at a temperature of 80°C using an extruder (produced by TOYO SEIKI Co., Ltd.). The number of the lumps was measured within the obtained test sheet, and then transparent quality thereof was evaluated.

According to the above results of the measurement of impregnation yield, the storage stability evaluation, the blocking evaluation, the appearance evaluation and the lump evaluation, the integrated evaluation of the resin composition for solar cell sealing material was carried out.

(Examples 2 to 7, Comparative Examples 1 to 7)

Pellets of a resin composition for solar cell sealing material were produced in the same procedure as Example 1, and then a test sheet was molded using these pellets, except that an ethylene-vinyl acetate copolymer and a crosslinking agent each shown in Table 2 were used, and impregnation processing conditions were set as shown in Table 2. Thereafter, the measurement, each of the evaluations and the integrated evaluation of the resin composition for solar cell sealing material were carried out.

(Comparative Example 8)

3, 600 parts of the ethylene-vinyl acetate copolymer (A-1) in the pellet form and 400 parts of the crosslinking agent (B-2) were kneaded at a processing temperature of 70°C and extruded using a biaxial extruder (produced by Nippon Placon Co. , Ltd.). In this way, produced were pellets of a resin composition for solar cell sealing material. And then, a test sheet was molded using these pellets. Thereafter, the measurement, each of the evaluations and the integrated evaluation of the resin composition for solar cell sealing material were carried out in the same manner as Example 1. Namely, in Comparative Example 8, the pellets of the resin composition for solar cell sealing material were produced without a step of impregnating the crosslinking agent (B-2) into the ethylene-vinyl acetate copolymer (A-1).

(Example 8)

Pellets of a resin composition for solar cell sealing material were produced using 3,200 parts of the ethylene-vinyl acetate copolymer (A-1) in the pellet form and 800 parts of the crosslinking agent (B-1) in the same procedure and impregnation processing conditions as Example 1, and then a test sheet was molded using these pellets. Thereafter, the measurement, each of the evaluations and the integrated evaluation of the resin composition for solar cell sealing material were carried out in the same manner as Example 1.

The raw components, the impregnation processing conditions and the evaluation results of Examples 1 to 8 and Comparative Examples 1 to 8 are shown in Table 2.

(Example 9)

Pellets of a resin composition for solar cell sealing material were produced using 3,200 parts of the ethylene-vinyl acetate copolymer (A-1) in the pellet form, 400 parts of the crosslinking agent (B-1) and 400 parts by weight of the crosslinking auxiliary agent (C-1) in the same procedure and impregnation processing conditions as Example 1, and then a test sheet was molded using these pellets. Thereafter, the measurement, each of the evaluations and the integrated evaluation of the resin composition for solar cell sealing material were carried out in the same manner as Example 1.

(Example 10)

Pellets of a resin composition for solar cell sealing material were produced using 3, 000 parts of the ethylene-vinyl acetate copolymer (A-1) in the pellet form, 400 parts of the crosslinking agent (B-1), 200 parts of the crosslinking auxiliary agent (C-1) and 200 parts of the silane coupling agent (D-1) in the same procedure and impregnation processing conditions as Example 9, and then a test sheet was molded using these pellets. Thereafter, the measurement, each of the evaluations and the integrated evaluation of the resin composition for solar cell sealing material were carried out in the same manner as Example 9.

(Example 11)

Pellets of a resin composition for solar cell sealing material were produced in the same procedure and impregnation processing conditions as Example 10, and then a test sheet was molded using these pellets, except that the silane coupling agent (D-1) was changed to the silane coupling agent (D-2). Thereafter, the measurement, each of the evaluations and the integrated evaluation of the resin composition for solar cell sealing material were carried out in the same manner as Example 10.

(Example 12)

2, 000 parts of the ethylene-vinyl acetate copolymer (A-1) in the pellet form and 1,100 parts of the crosslinking agent (B-1) were put into a 20 L mixer provided with a heating system (produced by KAWATA MFG CO., LTD.), and then mixed for 60 minutes at 500 rpm while being controlled at 40°C. In this way, produced were pellets of a resin composition for solar cell sealing material as a master batch. The measurement of impregnation yield, the storage stability evaluation, the blocking evaluation and the appearance evaluation of these pellets were carried out.

Further, 20 parts of the pellets produced by the impregnation method and 1,000 parts of the ethylene-vinyl acetate copolymer (A-1) as the dilution resin were put into a 20 L mixer (produced by KAWATA MFG CO., LTD.), and then mixed for 3 minutes at 500 rpm while being controlled at 25°C, to thereby obtain a mixture. Thereafter, a test sheet (solar cell sealing material sheet) having a thickness of 100 $\mu$m was obtained by molding the mixture at a processing temperature of 80°C using an extruder (produced by TOYO SEIKI Co. , Ltd.). The number of the lumps was measured within the obtained test sheet, and then transparent quality thereof was evaluated.

According to the above results of the measurement of impregnation yield, the storage stability evaluation, the blocking evaluation, the appearance evaluation and the lump evaluation, the integrated evaluation of the resin composition for solar cell sealing material produced as the master batch was carried out.

(Example 13)

Pellets of a resin composition for solar cell sealing material as a master batch were produced using 2,000 parts of the ethylene-vinyl acetate copolymer (A-1) in the pellet form, 550 parts of the crosslinking agent (B-1), 275 parts of the crosslinking auxiliary agent (C-1) and 275 parts of the silane coupling agent (D-1) in the same procedure and impregnation processing conditions as Example 12. Thereafter, the measurement of impregnation yield, the storage stability evaluation, the blocking evaluation and the appearance evaluation of these pellets were carried out in the same manner as Example 12.

Further, 40 parts of the pellets produced by the impregnation method and 1,000 parts of the ethylene-vinyl acetate copolymer (A-1) were put into a 20 L mixer (produced by KAWATA MFG CO., LTD.), and then mixed for 3 minutes at 500 rpm while being controlled at 25°C, to thereby obtain a mixture. Thereafter, a test sheet (solar cell sealing material sheet) having a thickness of 100 $\mu$m was obtained by molding the mixture at a processing temperature of 80°C using an extruder (produced by TOYO SEIKI Co. , Ltd.). The number of the lumps was measured within the obtained test sheet, and then transparent quality thereof was evaluated.

According to the above results of the measurement of impregnation yield, the storage stability evaluation, the blocking evaluation, the appearance evaluation and the lump evaluation, the integrated evaluation of the resin composition for solar cell sealing material produced as the master batch was carried out.

(Example 14)

Pellets of a resin composition for solar cell sealing material as a master batch were produced using 2,000 parts of the ethylene-vinyl acetate copolymer (A-1), 110 parts of the crosslinking agent (B-1), 55 parts of the crosslinking auxiliary agent (C-1) and 53 parts of the silane coupling agent (D-1) in the same procedure and impregnation processing conditions as Example 13. Thereafter, the measurement of impregnation yield, the blocking evaluation, the storage stability evaluation and the appearance evaluation of these pellets were carried out in the same manner as Example 13.

Further, 200 parts of the pellets produced by the impregnation method and 1,000 parts of the ethylene-vinyl acetate copolymer (A-1) were put into a 20 L mixer (produced by KAWATA MFG CO., LTD.), and then mixed for 3 minutes at 500 rpm while being controlled at 25°C, to thereby obtain a mixture. Thereafter, a test sheet (solar cell sealing material sheet) having a thickness of 100 $\mu$m was obtained by molding the mixture at a processing temperature of 80°C using an extruder (produced by TOYO SEIKI Co., Ltd.). The number of the lumps was measured within the obtained test sheet, and then transparent quality thereof was evaluated.

According to the above results of the measurement of impregnation yield, the storage stability evaluation, the blocking evaluation, the appearance evaluation and the lump evaluation, the integrated evaluation of the resin composition for solar cell sealing material produced as the master batch was carried out.

(Example 15)

Pellets of a resin composition for solar cell sealing material were produced in the same procedure and impregnation processing conditions as Example 9, and then a test sheet was molded using these pellets, except that the crosslinking auxiliary agent (C-1) was changed to the crosslinking auxiliary agent (C-2). Thereafter, the measurement, each of the evaluations and the integrated evaluation of the resin composition for solar cell sealing material were carried out in the same manner as Example 9.

(Example 16)

Pellets of a resin composition for solar cell sealing material were produced in the same procedure and impregnation processing conditions as Example 9, and then a test sheet was molded using these pellets, except that the crosslinking auxiliary agent (C-1) was changed to the crosslinking auxiliary agent (C-3). Thereafter, the measurement, each of the evaluations and the integrated evaluation of the resin composition for solar cell sealing material were carried out in the same manner as Example 9.

(Example 17)

Pellets of a resin composition for solar cell sealing material were produced in the same procedure and impregnation processing conditions as Example 10, and then a test sheet was molded using these pellets, except that the silane coupling agent (D-1) was changed to the silane coupling agent (D-3). Thereafter, the measurement, each of the evaluations and the integrated evaluation of the resin composition for solar cell sealing material were carried out in the same manner as Example 10.

(Comparative Example 9)

Pellets of a resin composition for solar cell sealing material were produced in the same procedure and impregnation processing conditions as Example 10, and then a test sheet was molded using these pellets, except that the crosslinking agent (B-1) was changed to the crosslinking agent (B-5). Thereafter, the measurement, each of the evaluations and the integrated evaluation of the resin composition for solar cell sealing material were carried out in the same manner as Example 10.

(Comparative Example 10)

3,200 parts of the ethylene-vinyl acetate copolymer (A-1) in the pellet form, 400 parts of the crosslinking agent (B-1) and 400 parts of the crosslinking auxiliary agent (C-1) were kneaded at a processing temperature of 70°C and extruded using a biaxial extruder (produced by Nippon Placon Co., Ltd.). In this way, produced were pellets of a resin composition for solar cell sealing material. And then, a test sheet was molded using these pellets. Thereafter, the measurement, each of the evaluations and the integrated evaluation of the resin composition for solar cell sealing material were carried out in the same manner as Example 9. Namely, in Comparative Example 10, the pellets of the resin composition for solar cell sealing material were produced without a step of impregnating each raw component into the ethylene-vinyl acetate copolymer (A-1).

(Comparative Example 11)

3, 000 parts of the ethylene-vinyl acetate copolymer (A-1) in the pellet form, 400 parts of the crosslinking agent (B-1), 400 parts of the crosslinking auxiliary agent (C-1) and 200 parts of the silane coupling agent (D-1) were kneaded at a processing temperature of 70°C and extruded using a biaxial extruder (produced by Nippon Placon Co., Ltd.). In this way, produced were pellets of a resin composition for solar cell sealing material. And then, a test sheet was molded using these pellets. Thereafter, the measurement, each of the evaluations and the integrated evaluation of the resin composition for solar cell sealing material were carried out in the same manner as Example 9. Namely, in Comparative Example 11, the pellets of the resin composition for solar cell sealing material were produced without a step of impregnating each raw component into the ethylene-vinyl acetate copolymer (A-1).

The evaluation results of Examples 9 to 17 and Comparative Examples 9 to 11 are shown in Table 3.
[Table 2]

Table 2

| | | Raw components | | Impregnation processing Impreg-conditions | | nation yield (%) | Evaluation | | | | | Integrated evaluation, |
|---|---|---|---|---|---|---|---|---|---|---|---|---|
| | | EVA | Cross-linking agent | Temp. (°C) | Time (min) | | Impregnation yield | Storage Stability | Blocking | Appearance | Lump | |
| Ex. | 1 | A-1 | B-1 | 40 | 30 | 98 | A | B | A | A | A | 3 |
| | 2 | A-2 | B-1 | 40 | 30 | 99 | A | B | A | A | A | 3 |
| | 3 | A-1 | B-1 | 70 | 30 | 97 | A | B | A | A | B | 2 |
| | 4 | A-2 | B-1 | 20 | 60 | 96 | A | B | A | A | A | 3 |
| | 5 | A-1 | B-2 | 40 | 30 | 98 | A | B | A | A | A | 3 |
| | 6 | A-1 | B-3 | 40 | 30 | 96 | A | B | A | A | A | 3 |
| | 7 | A-1 | B-4 | 40 | 30 | 97 | A | B | A | A | A | 3 |
| | 8 | A-1 | B-1 | 40 | 30 | 93 | B | B | A | A | A | 2 |
| Comp. Ex. | 1 | A-3 | B-1 | 40 | 60 | 57 | C | B | A | A | A | 1 |
| | 2 | A-4 | B-1 | 40 | 30 | 96 | A | B | B | B | A | 1 |
| | 3 | A-1 | B-5 | 40 | 30 | 84 | C | B | A | A | A | 1 |
| | 4 | A-1 | B-6 | 40 | 60 | 46 | C | C | A | A | A | 1 |
| | 5 | A-1 | B-7 | 40 | 30 | 87 | C | C | A | A | B | 1 |
| | 6 | A-2 | B-1 | 10 | 60 | 57 | C | B | A | C | A | 1 |
| | 7 | A-1 | B-1 | 90 | 30 | 76 | C | C | C | A | C | 1 |
| | 8 | A-1 | 3-1 | (molten and kneaded) | | 48 | C | B | A | A | C | 1 |

[Table 3]

Table 3

| | | Impregnation yield (%) | | | Evaluation | | | | | Integrated evaluation |
|---|---|---|---|---|---|---|---|---|---|---|
| | | Cross-linking auxiliary agent | Cross-linking agent | Silane coupling agent | Impregnation yield | Storage stability | Blocking | Appearance | Lump | |
| Ex. | 9 | 98 | 97 | | A | B | A | A | A | 3 |
| | 10 | 92 | 96 | 94 | A | B | A | A | B | 3 |
| | 11 | 93 | 94 | 92 | A | B | A | A | A | 3 |
| | 12 | 92 | | | A | A | A | A | A | 4 |
| | 13 | 94 | 90 | 91 | A | A | A | A | A | 4 |
| | 14 | 93 | 90 | 91 | A | A | A | A | A | 4 |
| | 15 | 98 | 88 | | B | B | B | B | A | 2 |
| | 16 | 96 | 84 | | B | B | B | B | A | 2 |
| | 17 | 84 | 96 | 76 | B | B | A | A | B | 2 |
| Comp. EX. | 9 | 84 | 94 | 92 | B | C | C | C | B | 1 |
| | 10 | 40 | 76 | | C | C | A | A | C | 1 |
| | 11 | 17 | 35 | 43 | C | C | A | A | C | 1 |

As evidenced by the results shown in Tables 2 and 3, by using the method for producing the resin composition for solar cell sealing material according to the present invention, it is possible to obtain a resin composition for solar cell sealing material having an anti-blocking property and excellent appearance in a short period of time. Further, by using such a resin composition for solar cell sealing material, it is possible to drastically suppress lumps from being generated, thereby producing a solar cell sealing material having good transparency.

## INDUSTRIAL APPLICABILITY

A method for producing a resin composition for solar cell sealing material according to the present invention includes: preparing an ethylene-vinyl acetate copolymer (A) containing a vinyl acetate unit in an amount of 25 to 35 wt% and a crosslinking agent (B), whose impregnation weight with respect to 1 g of the ethylene-vinyl acetate copolymer (A) per 24 hours at a temperature of 23°C is in the range of 40 to 80 mg, as raw components; and impregnating the crosslinking agent (B) into the ethylene-vinyl acetate copolymer (A) at a temperature of 15 to 80°C. Therefore, the produced resin composition for solar cell sealing material has good storage stability and is capable of lowering a cost by shortening of a processing time in manufacturing a solar cell sealing material. Further, the manufactured solar cell sealing material has excellent transparency by drastically reducing the number of lumps to be generated therein. A solar cell module provided with such a solar cell sealing material has improved performance and reliability. Thus, the present invention has industrial applicability.

## Claims

1. A method for producing a resin composition for solar cell sealing material, comprising:

preparing an ethylene-vinyl acetate copolymer (A) containing a vinyl acetate unit in an amount of 25 to 35 wt% and a crosslinking agent (B), whose impregnation weight with respect to 1 g of the ethylene-vinyl acetate copolymer (A) per 24 hours at a temperature of 23°C is in the range of 40 to 80 mg, as raw components; and impregnating the crosslinking agent (B) into the ethylene-vinyl acetate copolymer (A) at a temperature of 15 to 80°C.

2. The method for producing a resin composition for solar cell sealing material as claimed in claim 1, wherein surface tension of the crosslinking agent (B) is in the range of 23 to 28 mN/m.

3. The method for producing a resin composition for solar cell sealing material as claimed in claim 1, wherein in the raw components preparing step, a crosslinking auxiliary agent (C), whose impregnation weight with respect to 1 g of the ethylene-vinyl acetate copolymer (A) per 24 hours at a temperature of 23°C is in the range of 80 to 120 mg and whose surface tension is in the range of 33 to 38 mN/m, is further prepared as the raw components, and wherein in the crosslinking agent (B) impregnating step, the crosslinking auxiliary agent (C) is impregnated into the ethylene-vinyl acetate copolymer (A) together with the crosslinking agent (B).

4. The method for producing a resin composition for solar cell sealing material as claimed in claim 1, wherein in the raw components preparing step, a silane coupling agent (D), whose impregnation weight with respect to 1 g of the ethylene-vinyl acetate copolymer (A) per 24 hours at a temperature of 23°C is in the range of 80 to 150 mg and whose surface tension is in the range of 27 to 32 mN/m, is further prepared as the raw components, and wherein in the crosslinking agent (B) impregnating step, the silane coupling agent (D) is impregnated into the ethylene-vinyl acetate copolymer (A) together with the crosslinking agent (B).

5. A resin composition for solar cell sealing material being produced using the method for producing a resin composition for solar cell sealing material defined by claim 1.

6. A solar cell sealing material being molded using an ethylene-vinyl acetate copolymer and the resin material for solar cell sealing material defined by claim 5.

7. A method for molding a solar cell sealing material, comprising:

preparing an ethylene-vinyl acetate copolymer (A) containing a vinyl acetate unit in an amount of 25 to 35 wt% and a crosslinking agent (B), whose impregnation weight with respect to 1 g of the ethylene-vinyl acetate copolymer (A) per 24 hours at a temperature of 23°C is in the range of 40 to 80 mg, as raw components;

impregnating the crosslinking agent (B) into the ethylene-vinyl acetate copolymer (A) at a temperature of 15 to 80°C, to produce a master batch for solar cell sealing material;

mixing the produced master batch for solar cell sealing material with an ethylene-vinyl acetate copolymer while being heated, to obtain a mixture; and

molding the obtained mixture using a molding machine, to obtain the solar cell sealing material.

8. A solar cell module being manufactured by sealing a solar cell element with the solar cell sealing material defined by claim 6 or a solar cell sealing material molded by the method for molding a solar cell sealing material defined by claim 7.

<table>
<tr><td colspan="2" align="center">**INTERNATIONAL SEARCH REPORT**</td><td colspan="2">International application No.<br>PCT/JP2010/063388</td></tr>
</table>

| A. CLASSIFICATION OF SUBJECT MATTER |
|---|
| *H01L31/042*(2006.01)i, *C08J3/22*(2006.01)i, *C08K5/14*(2006.01)i, *C08K5/54* (2006.01)i, *C08L23/08*(2006.01)i, *C09K3/10*(2006.01)i |

According to International Patent Classification (IPC) or to both national classification and IPC

| B. FIELDS SEARCHED |
|---|
| Minimum documentation searched (classification system followed by classification symbols)<br>H01L31/042, C08J3/22, C08K5/14, C08K5/54, C08L23/08, C09K3/10 |

| Documentation searched other than minimum documentation to the extent that such documents are included in the fields searched |
|---|
| Jitsuyo Shinan Koho          1922–1996     Jitsuyo Shinan Toroku Koho      1996–2010<br>Kokai Jitsuyo Shinan Koho     1971–2010     Toroku Jitsuyo Shinan Koho      1994–2010 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X | JP 2006-186237 A  (Du Pont-Mitsui Polychemicals Co., Ltd.), 13 July 2006 (13.07.2006), paragraphs [0026] to [0027] (Family: none) | 1–8 |
| P,X | WO 2010/024176 A1  (Bridgestone Corp.), 04 March 2010 (04.03.2010), paragraphs [0019], [0023], [0026], [0039]; examples & JP 2010-053298 A | 1–8 |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>20 August, 2010 (20.08.10) | Date of mailing of the international search report<br>31 August, 2010 (31.08.10) |
|---|---|
| Name and mailing address of the ISA/<br>Japanese Patent Office | Authorized officer |
| Facsimile No. | Telephone No. |

Form PCT/ISA/210 (second sheet) (July 2009)

**EP 2 463 919 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000084967 A
- JP 2006186233 A